Europäisches Patentamt

European Patent Office

Office européen des brevets

(11) Publication number: **0 080 712**
**B1**

(12) **EUROPEAN PATENT SPECIFICATION**

(45) Date of publication of patent specification: **28.06.89**

(21) Application number: **82110938.6**

(22) Date of filing: **26.11.82**

(51) Int. Cl.⁴: **H 04 L 25/17,** H 04 N 9/64

(54) **Sampling frequency converting apparatus.**

(30) Priority: **27.11.81 JP 190312/81**

(43) Date of publication of application:
**08.06.83 Bulletin 83/23**

(45) Publication of the grant of the patent:
**28.06.89 Bulletin 89/26**

(84) Designated Contracting States:
**DE FR GB**

(56) References cited:
**GB-A-1 455 822**
**GB-A-2 039 195**
**US-A-3 934 094**

**PROCEEDINGS OF ICASSP 81, IEEE
INTERNATIONAL CONFERENCE ON
ACOUSTICS, SPEECH AND SIGNAL
PROCESSING, Atlanta, Georgia, US, 30th
March - 1st April 1981, vol. 1, pages 595-598,**

**IEEE, New York, US; R. LAGADEC et al.: "A
universal, digital sampling frequency converter
for digital audio"**

(73) Proprietor: **NEC CORPORATION**
**33-1, Shiba 5-chome, Minato-ku**
**Tokyo 108 (JP)**

(72) Inventor: **Takahashi, Hiroshi c/o NEC
CORPORATION**
**33-1, Shiba Gochome Minato-ku**
**Tokyo (JP)**

(74) Representative: **Glawe, Delfs, Moll & Partner
Patentanwälte**
**Postfach 26 01 62 Liebherrstrasse 20**
**D-8000 München 26 (DE)**

Courier Press, Leamington Spa, England.

**Description**

Background of the invention:

This invention relates to a sampling frequency converting apparatus for a digital television signal.

When a television signal is converted into a digital television signal, different sampling frequencies are frequently used in different television systems such as NTSC, PAL and SECAM systems, or in the same television system. If a plurality of digital units adopting respective different sampling frequencies are applied in a digital television signal transmission path, a sampling frequency converting apparatus is necessary to convert a digital signal with one sampling frequency $f_A$ to a digital signal with another sampling frequency $f_B$. To perform such a sampling frequency conversion in a purely digital manner, a frequency conversion method by means of a frequency of an integer multiplication of the sampling frqeuencies $f_A$ and $f_B$ has already been proposed in an Article "Sampling Rate Conversion for NTSC T.V." by B. G. Haskell, IEEE Communications Society, March 3, 1977. However, this prior art method requires a high speed logic circuit in comparison with the original sampling frequencies and must prepare different circuit constructions for the conversion ($f_A \rightarrow f_B$) and the conversion ($f_B \rightarrow f_A$). Hence, this method is not advantageous in conjunction with the circuit construction, the power consumption and the cost of production.

A frequency converting apparatus according to the preamble of claim 1 has been known from US—A—3 934 094. This prior art apparatus is preferably used for compression and expansion of the frequency band of audio signals, but not for sampling a television signal. This prior art apparatus requires an address designation signal controller, which is difficult to operate under the high sampling speeds required for television signal sampling.

It is an object of the invention to provide a sampling frequency converting apparatus of the aforementioned kind which does not require a high calculation speed for the conversion but makes it possible to convert one sampling frequency into the other sampling frequency in a simple manner.

For solving this object the invention provides a sampling frequency converting apparatus as defined in claim 1.

According to this invention, the maximal speed for the sampling frequency conversion is determined by the greater of the two sampling frequencies. The same circuit configuration can be used for the conversion from the first to the second sampling frequency and vice versa.

Preferred embodiments of the invention are described with reference to the drawings.

Figure 1(A) is a diagram for explaining the principle of the invention;

Figure 1(b) is a diagram showing the operation of the embodiment of the present invention;

Figure 2 shows one embodiment of the present invention;

Figure 2(a) shows the block diagram of a memory controller shown in Figure 2;

Figure 3 shows the basic construction of the interpolation filter;

Figure 4 shows a table of an example of the coefficients of the interpolation filter shown in Figure 4; and

Figure 5 shows another embodiment of the present invention.

Description of the preferred embodiments

In the following description, it is initially assumed that an input digital television signal which is sampled by a sampling frequency $f_A$ (cycle period $T_A$) is converted to an output digital television signal which is sampled by a sampling frequency $f_B$ (cycle period $T_B$) and that the relationship between the sampling frequency $f_A$ and the sampling frequency $f_B$ is defined by $f_A : f_B = M : N$ ($T_A : T_B = M : N$) (N, M: integer).

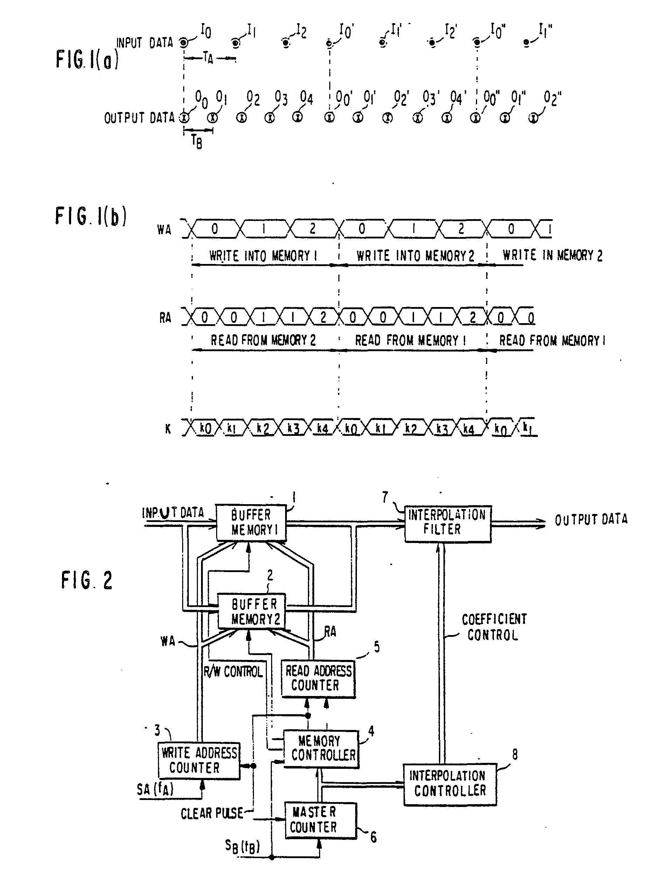

As clearly understood from Fig. 1(a), the sample point at the M-th data in the input digital television signal is coincident with the sample point at the N-th data in the output digital television signal. Hereinafter, the case of M=3 and N=5, i.e., $f_A : f_B = 3 : 5$ will be described for one example. In Figure 1(a), the input data, train is sequentially expressed as $I_0$, $I_1$, $I_2$, $I'_0$, $I'_1$, $I'_2$, ... and the converted output data train is sequentially expressed as $O_0$, $O_1$, $O_2$, $O_3$, $O_4$, $O'_0$, $O'_1$, $O'_2$, $O'_3$, $O''_0$, ... respectively. The output data $O_0$ is produced from the input data $I_0$ and $I_1$ by linear interpolation. Similarly, the output data $O_1$ and $O_2$ are produced from the output data $I_0$ and $I_1$, and $I_1$ and $I_2$, respectively, by the linear interpolation. Here, with respect to the output data $O_0$ and the output data $O_1$, the same sampling points corresponding to the input data $I_0$ and $I_1$ are used for the interpolation, but their interpolation coefficients are different. This relation also holds true for the output data $O_2$ and $O_3$ and this relation is repeated every five output data.

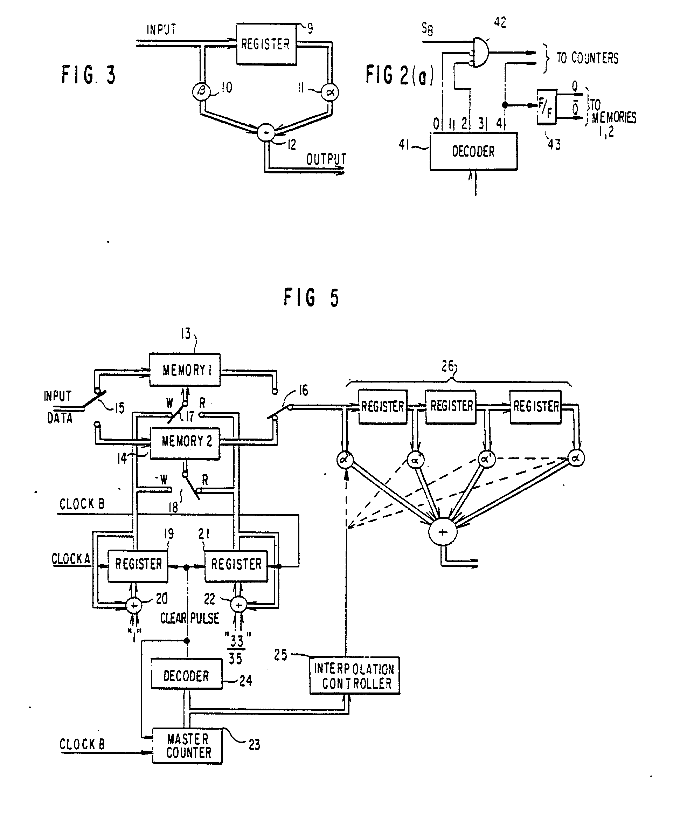

Figure 2 shows a first embodiment of the present invention. The input data of the input digital television signal are applied to buffer memories 1 and 2 juxtaposed with each other and are alternately stored in the memories 1 and 2 in accordance with a write-address produced by a write-address counter 3. The stored data in the buffer memories 1 and 2 are alternately read out in accordance with a read-address produced by a read-address counter 5. Accordingly, when either one of the buffer memories 1 and 2 is in the write-mode, the other is in the read-mode. Furthermore, the write or read-mode of the memories 1 and 2 is interchanged every M input data. For example, after the M data of the input data are stored in the memory 1, the next input M data are stored in the memory 2. The write-address is produced in the write-in address counter by counting a clocks of the frequency $f_A$ (period $T_A$) and being cleared every M counts under the control of a clear pulse.

A master counter 6 counts the second sampling pulses $S_B$ (period $T_B$) and is cleared by the clear pulse. The output of the master counter 6 is applied to a memory controller 4. The memory controller 4 is composed of a decoder 41, a gate 42 and a flip-flop 43 as shown in Figure 2(a). The decoder 41 produces N timing pulses during N periods of the second sampling pulses $S_B$. The last timing pulse delivered from the decoder 41 is supplied to the flip-flop 43 as the clear pulse. The Q and $\bar{Q}$ output of the flip-flop 43 are supplied to the memories 1 and 2 as a write/read control signal, respectively. The gate 42 inhibits two clocks of the second sampling pulses $S_B$ during N periods, i.e., the one clear pulse period.

The read-address counter 5 counts the clocks delivered from the gate 42 and is cleared by the clear pulse. The read-address from the counter 5 is applied to the memories 1 and 3. It is noticed that the one period of the clear pulse just contains M clocks of the frequency $f_A$ and N clocks of the frequency $f_B$. The sampling period in the read data alternately derived from the memories 1 and 2 is converted from $T_A$ to $T_B$ and the read data are then supplied to an interpolation filter 7, where the data at sampling points are processed for the interpolation. The interpolation coefficient of the interpolation filter 7 is controlled by an interpolation controller 8 in synchronism with the clocks of the frequency $f_B$. The interpolation controller 8 receives the output of the master counter 6.

Figure 1(b) is a diagram showing the relationship between the write-address and the read-address supplied to the buffer memories 1 and 2, and the coefficients of the interpolation filter. Here, the write-address WA repeats 0, 1, 2, ... and the first three data are written to the buffer memory 1 and the next three data, to the buffer memory 2. In contrast, the read-address RA has five addresses corresponding to the three write-addresses and the designated addresses are 0, 0, 1, 1 and 2. The flow of the read-address is performed by the gate 42 in the memory controller 4. These memories are arranged so that when the write-operation is made to the buffer memory 1, the read-operation can be made to the buffer memory 2 and the write-operation and the read-operation are not made to the same memory as described above. A transversal filter is generally used as the interpolation filter. If coefficients to be multiplied to each delay output are $k_0$—$k_4$, the control output K of the interpolation controller 8 (Figure 2) is such as shown in Figure 1(b). In the embodiment shown in Figure 2, the memory controller 4 and the read-address counter can be substituted to a read-only memory (ROM) which stores the flow of the read-addresses 0, 0, 1, 1 and 2.

When the sampling frequency conversion is effected between two different sampling frequencies according to the present invention, the memory controller 4, the interpolation filter 7 and the coefficient for the interpolation filter are changed in accordance with the input and output sampling frequencies. These portions to be changed are constructed by a programmable ROM (P-ROM) so as to change the content of the program in accordance with the change of the sampling frequencies and if the buffer memories have sufficient capacity, the same circuit can cope with the change of the sampling frequencies.

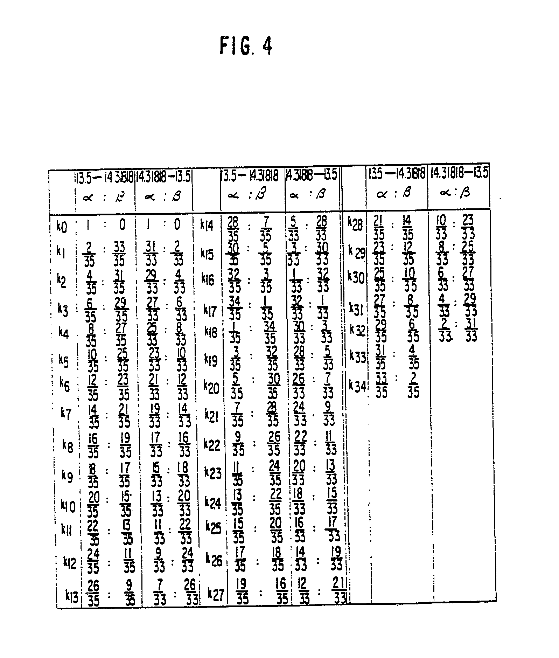

Next, conversion of sampling frequencies of the NTSC TV system will be described by way of example. Here, conversion will be considered between the sampling frequency (14.31818 MHz), i.e., the four times subcarrier frequency which has been widely used conventionally and 13.5 MHz frequency which is scheduled to be a world-wide standard sampling frequency in a digital television signal processing. In this case, $f_A$=13.5 MHz, $f_B$=14.31818 MHz and $T_A$:$T_B$=N:M=33:35. In Figure 2, the buffer memories 1 and 2 in this case must have capacity to store 33 data of the input digital television signals. As the interpolation filter 7 shown in Figure 2, a higher order interpolation filter is practically used in order to satisfy the gain and phase characteristics within a necessary frequency band. For ease of explanation, linear interpolation using two adjacent sampling points such as shown in Figure 3 will be considered. The coefficients $k_0$, $k_1$, ..., $k_n$, ... $k_{34}$ produced from the interpolation controller becomes such as shown in Figure 4. In the sampling frequency conversion from 13.5 MHz to 14.31818 MHz, 35 pairs of coefficients α and β are used as shown in Figure 4. Since it is obvious that the alignment of the coefficients is symmetric with the center of $k_{17}$ and $k_{18}$, the number of the coefficients stored in the interpolation controller can be reduced by using this symmetry. On the other hand, in the sampling frequency conversion from 14.31817 MHz to 13.5 MHz, M:N=35:33, the number of the coefficients becomes 33 of $k_0$ to $k_{32}$ as also shown in Figure 4.

Referring to Figure 5, a second embodiment also contains two buffer memories 13 and 14. The second embodiment is differentiated from the first embodiment shown in Figure 2 in that the alternative interchange operation of the memories 13 and 14 is performed by switches 15, 16, 17 and 18, and a write-address and a read-address are produced by the combination of registers 19 and 21 and adders 20 and 22. The address production will be described in detail hereinafter. In the second embodiment, the sampling frequency 13.5 MHz is converted to the sampling frequency 14.31818, for example. A master counter 23 counts clocks of the frequency 14.31818 and supplies the output to a decoder 24 and an interpolation controller 25. The decoder 24 produces a clear pulse, which is similar to the clear pulse derived from the memory controller 4 shown in Figure 2, for the registers 19 and 21 and the master counter 23. The write-address is produced by the combination of the register 19 and the adder 20. This combination increases the output of the register 19 by "1" in synchronism with the clocks A (13.5 MHz) and the output is supplied to the memory 13 or 14 as the write-address. On the other hand, the combination including the register 21 and the adder 22 increases the output of the register 21 by "33/35" in synchronism with the clocks B (14.41818 MHz).

The integer portion of the output of the register 21 is applied to the memory 13 or 14 as the read-address. The read data from the memory 13 or 14 are supplied to a transversal filter 26 where the read data are processed for the interpolation.

In the second embodiment, though the sampling frequency conversion from the lower frequency to the higher frequency is performed, it is obvious that conversion in the reverse manner can be made by changing the preset value with the same circuit construction.

Though the foregoing illustrates the sampling frequency conversion for the NTSC TV system by way of the example, sampling conversion for the PAL system or other systems can be similarly made according to the present invention.

As described in detail in the foregoing, the present invention provides the sampling frequency converting apparatus which does not need calculation elements having high speed and yet, is extremely simple in construction.

## Claims

1. A sampling frequency converting apparatus for converting an input digital signal sampled by a first frequency $f_A$ to an output digital signal sampled by a second frequency $f_B$, the ratio between $f_A$ and $f_B$ being M/N (with M, N being integers), comprising first and second memory means (1, 2), (13, 14), address means (3, 4, 5, 6), (19, 20, 21, 22, 23, 24) including a write-address producing means (3), (19, 20) and a read-address producing means (5), (21, 22) and filtering means (7, 8), (25, 26) characterized in that said write-address producing means (3), (19, 20) produces a write-address in response to a first signal at said first frequency $f_A$ by M times incrementing an initial value of said address by one so as to store M data of said input digital signal in said first memory means (1), (13), and said write-address producing means being cleared after said M increments and being switched to store subsequent M data of said input digital signal in said second memory means (2), (14);

said read-address producing means (5), (21, 22) produces a read-address in response to a second signal at said second frequency $f_B$ by N times incrementing an initial value of said address by one so as to read out stored data from said second memory means (2), (14), and said read-address producing means being cleared after said N increments and being switched to read out subsequent stored data from said first memory means (1), (13); and said filtering means (7, 8), (25, 26) includes interpolating means (7), (26) for interpolating the read out data from said first and second memory means (1, 2), (13, 14), said interpolating means (7), (26) having N interpolation coefficients.

2. A sampling frequency converting apparatus as claimed in claim 1, characterized in that said address means (3, 4, 5, 6) further includes a master counter (6) receiving said second signal at said second frequency $f_B$ for producing a master count output and a memory controller (4) receiving said master count output as a count input for producing a clearing pulse to clear said write-address producing means (3), said read-address producing means (5) and said master counter (6) and for producing a switching signal to switch write/read alternation of said first and second memory means (1) and (2); and

said filtering means (7, 8) further includes an interpolation controller (8) storing a plurality of interpolation coefficients corresponding to said N coefficients to deliver said interpolation coefficients to said interpolating means (7) in response to said master count output produced by said master counter (6).

3. A sampling frequency converting apparatus as claimed in claim 1, characterized in that said write-address producing means (19, 20) includes a combination of register (19) and an adder (20), said register (19) receiving said first signal at said first frequency $f_A$ as an operation clock and delivering said write-address to said first memory means (13) or said second memory means (14) and to said adder (20), said adder (20) adding said write-address from said register (19) and an initial value and delivering the added value to said register (19);

said read-address producing means (21, 22) includes a combination of a register (21) and an adder (22), said register (21) receiving said second signal at said second frequency $f_B$ as an operation clock and delivering said read address to said second memory means (14) or said first memory means (13) and to said adder (22), said adder (22) adding said read-address from said register (21) and an initial value and delivering the added value to said register (21);

said address means (19, 20, 21, 22, 23, 24) further includes a master counter (23) receiving said second signal at said second frequency $f_B$ as a count clock to deliver a master count output and a decoder (24) receiving said master count output to deliver a clear pulse to said registers (19), (21) and said master counter (23); and

said filtering means (25, 26) further includes an interpolation controller (25) storing a plurality of interpolation coefficients corresponding to said N coefficients to deliver said interpolation coefficients to said interpolating means (26) in response to said master count output from said master counter (23).

## Patentansprüche

1. Abtast-Frequenz-Umsetzeinrichtung zum Umwandeln eines digitalen Eingangssignals, welches durch eine erste Frequenz ($f_A$) abgetastet ist, in ein digitales Ausgangssignal, das von einer zweiten Frequenz ($f_B$) abgetastet ist, wobei das Verhältnis von ($f_A$) zu ($f_B$) M/N ist (mit M, N=ganze Zahlen), mit ersten und zweiten Speichermitteln (1, 2), (13, 14), Adressenmitteln (3, 4, 5, 6), (19, 20, 21, 22, 23, 24) mit einer Schreibadressen erzeugenden Einrichtung (3), (19, 20) und einer Leseadressen erzeugenden Einrichtung (5), (21, 22) und Filterelementen (7, 8) (25, 26) dadurch gekennzeichnet, daß die Schreibadressen erzeugende Einrichtung (3), (19, 20) in Abhängigkeit von einem ersten Signal an der ersten Frequenz ($f_A$) eine Schreibadresse erzeugt, indem ein Anfangswert der Adresse M mal um 1 erhöht wird, um das M-Data dieses digitalen Eingangssignals in den ersten Speichermitteln (1), (13) zu speichern und die Schreibadressen erzeugende Einrichtung (3) nach den M Erhöhungen gelöscht wird und so geschaltet wird, daß das darauffolgende M-Data des digitalen Eingangssignals in den zweiten Speichermitteln (2), (14) gespeichert wird;

daß die Leseadressen erzeugende Einrichtung (5), (21, 22) in Abhängigkeit von einem zweiten Signal an der zweiten Frequenz'($f_B$) erzeugt wird, indem ein Anfangswert der Adressen N mal um 1 erhöht wird, um das gespeicherte Data der Adresse aus dem zweiten Speichermittel (2, 14) zu lesen und die Leseadressen erzeugende Einrichtung nach den N-Erhöhungen gelöscht wird, um das folgende gespeicherte Data aus den ersten Speichermitteln (1), (13) zu lesen; und daß die Filterelemente (7, 8), (25, 26) interpolierende Mittel (7), (26) zum Interpolieren der aus den ersten und zweiten Speichermitteln (1, 2), (13, 14) gelesenen Daten aufweisen, wobei die interpolierenden Mittel (7), (26) N Interpolationskoeffizienten haben.

2. Abtast-Frequenz-Umsetzeinrichtung nach Anspruch 1, dadurch gekennzeichnet, daß die Adressenmittel (3, 4, 5, 6) weiterhin einen Hauptzähler (6) aufweisen, der das zweite Signal an der zweiten Frequenz ($f_B$) erhält, um einen Hauptzählausgang zu erzeugen, wobei ein Speicherregler (4) diesen Hauptzählausgang als einen Zähleingang erhält, um einen Löschimpuls zu erzeugen, um die Schreibadressen erzeugende Einrichtung (3), die Leseadressen erzeugende Einrichtung (5) und den Hauptzähler (6) zu löschen und um ein Schaltsignal zu erzeugen, um den Schreib/Lese-Wechsel der ersten und zweiten Speichermittel (1) und (2) zu schalten;

und daß die Filterelemente (7, 8) weiterhin einen Interpolations regler (8) aufweisen, der eine Anzahl von Interpolationskoeffizienten entsprechend den N Koeffizienten speichert, um diese Interpolationskoeffizienten in Abhängigkeit von dem vom Hauptzähler erzeugten Hauptzählausgang an die interpoliertenden Mittel (7) zu liefern.

3. Abtast-Frequenz-Umsetzeinrichtung nach Anspruch 1, dadurch gekennzeichnet, daß die Schreibadressen erzeugende Einrichtung (19, 20) eine Kombination aus Register (19) und Addierwerk (20) aufweist, wobei das Register (19) das erste Signal an der ersten Frequenz ($f_A$) als einen Operationstakt empfängt und die Schreibadresse auf das erste Speichermittel (13) oder zweite Speichermittel (14) und das Addierwerk (20) liefert, wobei das Addierwerk (20) diese Schreibadresse vom Register (19) und einen Anfangswert addiert und den Additionswert an das Register (19) liefert; daß die Leseadressen erzeugende Einrichtung (21, 22) eine Kombination aus einem Register (21) und einem Addierwerk (22) aufweist, wobei das Register (21) das zweite Signal an der zweiten Frequenz ($f_B$) als Operationstakt empfängt und diese Leseadresse auf das zweite Speichermittel (14) oder erste Speichermittel (13) und das Addierwerk (22) liefert, wobei das Addierwerk (22) die Leseadresse vom Register (21) und einen Anfangswert addiert und den Additionswert an das Register (21) liefert;

daß die Adressenmittel (19, 20, 21, 22, 23, 24) weiterhin einen Hauptzähler (23) aufweisen, der das zweite Signal an der zweiten Frequenz ($f_B$ als Zähltakt empfängt, um einen Hauptzählausgang zu liefern und ein Dekoder (24) diesen Hauptzählausgang empfängt, um einen Löschimpuls an das Register (19, 21) und den Hauptzähler (23) zu liefern, und

daß die Filterelemente (25, 26) weiterhin einen Interpolationsregler (25) aufweisen, der eine Anzahl von Interpolationskoeffizienten entsprechend der N Koeffizienten speichert, um diese Interpolationskoeffizienten in Abhängigkeit von dem Hauptzählausgang vom Hauptzähler (23) an die interpolierenden Mittel (26) zu liefern.

**Revendications**

1. Dispositif de conversion de fréquence d'échantillonnage pour convertir un signal numérique d'entrée échantillonné par une première fréquence $f_A$ en signal numérique de sortie échantillonné par une seconde fréquence $f_B$, le rapport entre $f_A$ et $f_B$ étant M/N (M, N étant des nombres entiers), comprenant des premier et second moyens de mémoire (1, 2), (13, 14), des moyens d'adresse (3, 4, 5, 6), (19, 20, 21, 22, 23, 24) comportant un moyen de production d'adresse d'écriture (3), (19, 20) et un moyen de production d'adresse de lecture (5), (21, 22) et un moyen de filtrage (7, 8), (25, 26), caractérisé en ce que:

le moyen de production d'adresse d'écriture (3), (19, 20) produit une adresse d'écriture en réponse à un premier signal à la première fréquence $f_A$ en incrémentante M fois une valeur initiale de l'adresse par un de manière à stocker M données du signal numérique d'entrée dans le premier moyen de mémoire (1), (13), et le moyen de production d'adresse d'écriture étant effacé après les M incréments et étant commuté pour stocker M données suivantes du signal numérique d'entrée dans le second moyen de mémoire (2), (14);

le moyen de production d'adresse de lecture (5), (21, 22) produit une adresse de lecture en réponse à un second signal à la seconde fréquence $f_B$ en incrémentant N fois une valeur initiale de l'adresse par un de manière à lire la donnée stockée dans le second moyen de mémoire (2) (14), et le moyen de production d'adresse de lecture étant effacé après les N incréments et étant commuté de manière à lire des données stockées ultérieures dans le premier moyen de mémoire (1), (13); et

le moyen de filtrage (7, 8), (25, 26) comprend un moyen d'interpolation (7), (26) pour interpoler la donnée lue dans les premier et second moyens de mémoire (1, 2), (13, 14), le moyen d'interpolation (7), (26) comportant N coefficients d'interpolation.

2. Dispositif de conversion de fréquence d'échantillon selon la revendication 1, caractérisé en ce que le moyen d'adresse (3, 4, 5, 6) comprend en outre un compteur principal (6) recevant le second signal à la seconde fréquence $f_B$ pour produire un comptage de sortie principal et un contrôleur (4) de mémoire recevant le comptage de sortie principal comme comptage d'entrée afin de produire une impulsion d'effacement pour effacer le moyen de production d'adresse d'écriture (3), le moyen de production d'adresse de lecture (5) et le compteur principal (6) et pour produire un signal de commutation de manière à commuter l'alternance écriture/lecture des premier et second moyens de mémoire (1) et (2), et

le moyen de filtrage (7, 8) comprend en outre un contrôleur d'interpolation (8) stockant une multitude de coefficients d'interpolation correspondant aux N coefficients pour délivrer les coefficients d'interpolation au moyen d'interpolation (7) en réponse au comptage de sortie principal produit par le compteur principal (6).

3. Dispositif de conversion de fréquence d'échantillonnage selon la revendication 1, caractérisé en ce que le moyen de production d'adresse d'écriture (19, 20) comprend la combinaison d'un registre (19) et d'un additionneur (20), le registre (19) recevant le premier signal à la première fréquence $f_A$ comme horloge de fonctionnement et délivrant l'adresse d'écriture au premier moyen de mémoire (13) ou au second moyen de mémoire (14) et à l'additionneur (20), l'additionneur (20) ajoutant l'adresse d'écriture provenant du register (19) et une valeur initiale et délivrant la valeur ajoutée au register (19),

le moyen de production d'adresse de lecture (21, 22) comprend la combinaison d'un registre (21) et d'un additionneur (22), le registre (21) recevant le second signal à la seconde fréquence $f_B$ comme horloge de fonctionnement et délivrant l'adresse de lecture au second moyen de mémoire (14) ou au premier moyen de mémoire (13) et à l'additionneur (22), l'additionneur (22) ajoutant l'adresse de lecture provenant du register (21) et une valeur initiale et délivrant la valeur ajoutée au registre (21),

le moyen d'adresse (19, 20, 21, 22, 23, 24) comprend en outre un compteur principal (23) recevant le second signal à la seconde fréquence $f_B$ comme horloge de comptage pour délivrer un comptage de sortie principal et un décodeur (24) recevant le comptage de sortie principal pour délivrer une impulsion d'effacement aux registres (19, 21) et au compteur principal (23); et

le moyen de filtrage (25, 26) comprend en outre un contrôleur d'interpolation (25) stockant une multitude de coefficients d'interpolation correspondant aux N coefficients afin de délivrer les coefficients d'interpolation au moyen d'interpolation (26) en réponse au comptage de sortie principal provenant du compteur principal (23).

FIG. 1(a)

FIG. 1(b)

FIG. 2

FIG. 3

FIG 2(a)

FIG 5

# FIG. 4

| | 13.5 — 14.3188 | | 14.3188 — 13.5 | | | 13.5 — 14.3188 | | 14.3188 — 13.5 | | | 13.5 — 14.3188 | | 14.3188 — 13.5 | |
|---|---|---|---|---|---|---|---|---|---|---|---|---|---|---|
| | $\alpha$ | : $\beta$ | $\alpha$ | : $\beta$ | | $\alpha$ | : $\beta$ | $\alpha$ | : $\beta$ | | $\alpha$ | : $\beta$ | $\alpha$ | : $\beta$ |
| $k_0$ | 1 | : 0 | 1 | : 0 | $k_{14}$ | $\frac{28}{35}$ | : $\frac{7}{35}$ | $\frac{5}{33}$ | : $\frac{28}{33}$ | $k_{28}$ | $\frac{21}{35}$ | : $\frac{14}{35}$ | $\frac{10}{33}$ | : $\frac{23}{33}$ |
| $k_1$ | $\frac{2}{35}$ | : $\frac{33}{35}$ | $\frac{31}{33}$ | : $\frac{2}{33}$ | $k_{15}$ | $\frac{30}{35}$ | : $\frac{5}{35}$ | $\frac{3}{33}$ | : $\frac{30}{33}$ | $k_{29}$ | $\frac{23}{35}$ | : $\frac{12}{35}$ | $\frac{8}{33}$ | : $\frac{25}{33}$ |
| $k_2$ | $\frac{4}{35}$ | : $\frac{31}{35}$ | $\frac{29}{33}$ | : $\frac{4}{33}$ | $k_{16}$ | $\frac{32}{35}$ | : $\frac{3}{35}$ | $\frac{1}{33}$ | : $\frac{32}{33}$ | $k_{30}$ | $\frac{25}{35}$ | : $\frac{10}{35}$ | $\frac{6}{33}$ | : $\frac{27}{33}$ |
| $k_3$ | $\frac{6}{35}$ | : $\frac{29}{35}$ | $\frac{27}{33}$ | : $\frac{6}{33}$ | $k_{17}$ | $\frac{34}{35}$ | : $\frac{1}{35}$ | $\frac{32}{33}$ | : $\frac{1}{33}$ | $k_{31}$ | $\frac{27}{35}$ | : $\frac{8}{35}$ | $\frac{4}{33}$ | : $\frac{29}{33}$ |
| $k_4$ | $\frac{8}{35}$ | : $\frac{27}{35}$ | $\frac{26}{33}$ | : $\frac{8}{33}$ | $k_{18}$ | $\frac{1}{35}$ | : $\frac{34}{35}$ | $\frac{30}{33}$ | : $\frac{3}{33}$ | $k_{32}$ | $\frac{29}{35}$ | : $\frac{6}{35}$ | $\frac{2}{33}$ | : $\frac{31}{33}$ |
| $k_5$ | $\frac{10}{35}$ | : $\frac{25}{35}$ | $\frac{23}{33}$ | : $\frac{10}{33}$ | $k_{19}$ | $\frac{3}{35}$ | : $\frac{32}{35}$ | $\frac{28}{33}$ | : $\frac{5}{33}$ | $k_{33}$ | $\frac{31}{35}$ | : $\frac{4}{35}$ | | |
| $k_6$ | $\frac{12}{35}$ | : $\frac{23}{35}$ | $\frac{21}{33}$ | : $\frac{12}{33}$ | $k_{20}$ | $\frac{5}{35}$ | : $\frac{30}{35}$ | $\frac{26}{33}$ | : $\frac{7}{33}$ | $k_{34}$ | $\frac{33}{35}$ | : $\frac{2}{35}$ | | |
| $k_7$ | $\frac{14}{35}$ | : $\frac{21}{35}$ | $\frac{19}{33}$ | : $\frac{14}{33}$ | $k_{21}$ | $\frac{7}{35}$ | : $\frac{28}{35}$ | $\frac{24}{33}$ | : $\frac{9}{33}$ | | | | | |
| $k_8$ | $\frac{16}{35}$ | : $\frac{19}{35}$ | $\frac{17}{33}$ | : $\frac{16}{33}$ | $k_{22}$ | $\frac{9}{35}$ | : $\frac{26}{35}$ | $\frac{22}{33}$ | : $\frac{11}{33}$ | | | | | |
| $k_9$ | $\frac{18}{35}$ | : $\frac{17}{35}$ | $\frac{15}{33}$ | : $\frac{18}{33}$ | $k_{23}$ | $\frac{11}{35}$ | : $\frac{24}{35}$ | $\frac{20}{33}$ | : $\frac{13}{33}$ | | | | | |
| $k_{10}$ | $\frac{20}{35}$ | : $\frac{15}{35}$ | $\frac{13}{33}$ | : $\frac{20}{33}$ | $k_{24}$ | $\frac{13}{35}$ | : $\frac{22}{35}$ | $\frac{18}{33}$ | : $\frac{15}{33}$ | | | | | |
| $k_{11}$ | $\frac{22}{35}$ | : $\frac{13}{35}$ | $\frac{11}{33}$ | : $\frac{22}{33}$ | $k_{25}$ | $\frac{15}{35}$ | : $\frac{20}{35}$ | $\frac{16}{33}$ | : $\frac{17}{33}$ | | | | | |
| $k_{12}$ | $\frac{24}{35}$ | : $\frac{11}{35}$ | $\frac{9}{33}$ | : $\frac{24}{33}$ | $k_{26}$ | $\frac{17}{35}$ | : $\frac{18}{35}$ | $\frac{14}{33}$ | : $\frac{19}{33}$ | | | | | |
| $k_{13}$ | $\frac{26}{35}$ | : $\frac{9}{35}$ | $\frac{7}{33}$ | : $\frac{26}{33}$ | $k_{27}$ | $\frac{19}{35}$ | : $\frac{16}{35}$ | $\frac{12}{33}$ | : $\frac{21}{33}$ | | | | | |